# EUROPÄISCHE PATENTSCHRIFT

(11) **EP 4 292 135 B1**
(45) Veröffentlichungstag und Bekanntmachung des Hinweises auf die Patenterteilung: **09.09.2026**
(21) Anmeldenummer: 22708061.1
(22) Anmeldetag: 08.02.2022
(51) Int. Cl.: H10F 19/70, H02S 40/34

(54) **PHOTOVOLTAIKMODUL UND EIN VERFAHREN ZUR DESSEN HERSTELLUNG**
PHOTOVOLTAIC MODULE AND METHOD FOR PRODUCING SAME
MODULE PHOTOVOLTAÏQUE ET SON PROCÉDÉ DE FABRICATION

(30) Priorität: 10.02.2021 DE 102021103099
(43) Veröffentlichungstag der Anmeldung: 20.12.2023
(73) Patentinhaber: Hanwha Q CELLS GmbH, 06766 Bitterfeld-Wolfen (DE)
(72) Erfinder: METTE, Michael, 06766 Bitterfeld-Wolfen (DE); HARDER, Thoralf, 06766 Bitterfeld-Wolfen (DE)
(74) Vertreter: LifeTech IP Spies & Behrndt Patentanwälte PartG mbB
(86) Internationale Anmeldenummer: PCT/EP2022/052964
(87) Internationale Veröffentlichungsnummer: WO 2022/171602

(56) Entgegenhaltungen:
- EP-A1- 2 249 394
- CN-A- 109 301 010
- DE-A1- 102011 055 754
- US-A1- 2017 054 047

## Beschreibung

Die vorliegende Erfindung bezieht sich auf ein Photovoltaikmodul und auf ein Verfahren zu dessen Herstellung und insbesondere auf ein Verbindungsschema für Photovoltaikzellen (Solarzellen) mit Überbrückungsdioden (Bypass-Dioden).

### HINTERGRUND

Solarzellen erzeugen bei Sonnenbestrahlung freie Ladungsträger, die einen Stromfluss durch die Solarzelle erlauben. Falls es zu Abschattungen kommt, werden in den abgeschatteten Solarzellen keine Ladungsträger freigesetzt, sodass der Stromfluss dort unterbrochen wird bzw. einem höheren Widerstand ausgesetzt sind. Wenn die anderen Solarzellen, die mit der abgeschatteten Solarzelle seriell verschaltet sind, weiterhin Strom produzieren, führt dies zu einer erhöhten Wärmeerzeugung und im Extremfall zu einer Zerstörung der entsprechenden Solarzellen. Um dies zu vermeiden, werden sogenannte Bypass-Dioden ausgebildet, die die Zellen mit hohem Widerstand überbrücken, sodass diese Zellen geschützt werden. Wenn wieder ausreichend Lichtenergie zur Verfügung steht, werden mehr Ladungsträger freigesetzt und die Bypass-Dioden sperren wieder.

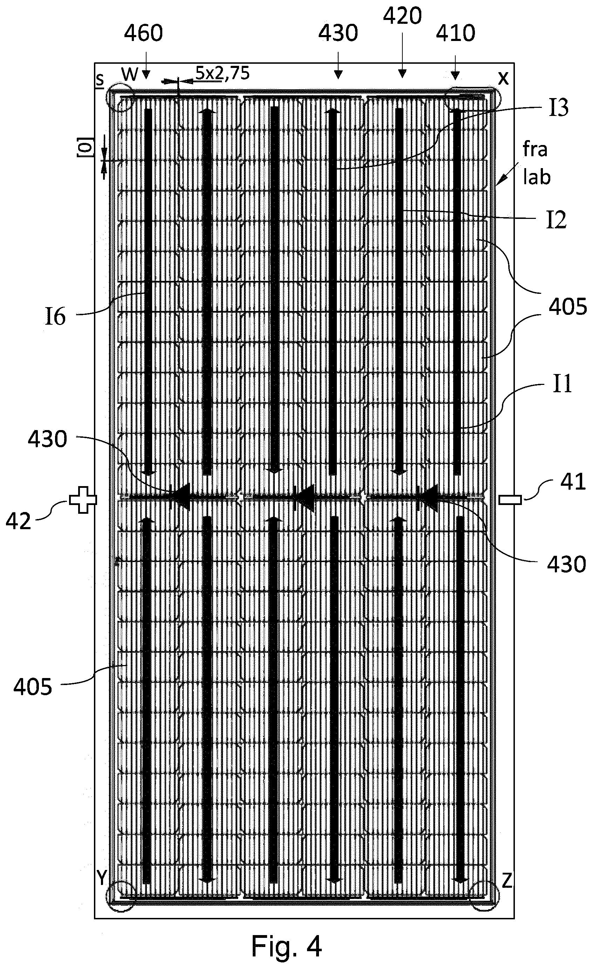

**Fig. 4** zeigt eine beispielhafte konventionelle Verschaltung von Solarzellen 405 mit Bypass-Dioden 430, wobei die Solarzellen 405 (bzw. Halbzellen) derart verschaltet sind, dass sich im Betrieb ein mäanderförmiger Stromfluss I1, I2, ... zwischen einem ersten Terminal 41 und einem zweiten Terminal 42 ergibt. Konkret sind die Solarzellen 405 in mehreren Zellreihen 410, 420, 430, ... 460 seriell verschaltet. Die Zellreihen sind senkrecht zu der Stromrichtung I1, I2, ... nebeneinander angeordnet, wobei benachbarte Zellreihen 410, 420 eine entgegengesetzt Stromrichtung I1, I2 aufweisen. Die Bypass-Dioden 430 überbrücken die benachbarten Zellreihen 410, 420 entgegengesetzter Stromrichtungen I1, I2.

Spiegelsymmetrisch zu dieser Verschaltung von Zellreihen 410, 420, 430, ... sind in einem unteren Teil weitere Solarzellen in gleicher Weise verschaltet, wobei die Spiegelebene entlang der Verbindungslinie zwischen dem ersten und dem zweiten Terminal 41, 42 verläuft. In dieser konventionellen Anordnung überbrück somit jeweils eine Bypass-Diode 430 vier Zellreihen von Solarzellen 405, zwei vertikal oberhalb und zwei vertikal unterhalb der Bypass-Diode 430 gelegene Zellreihen. In dem Beispiel aus der Fig. 4 sind es insgesamt drei Bypass-Dioden 430, die beispielhaft 156 Solarzellen oder Halbzellen in 12 Zellreihen überbrücken.

Diese konventionelle Verschaltung bietet den Nachteil, dass relativ große Abschnitte des Photovoltaikmoduls mit einer Bypass-Diode 430 überbrückt werden. Insbesondere erstrecken diese Abschnitte sich über die gesamte vertikale Höhe des Photovoltaikmoduls. Abschattungen führen zu einem abschalten einer Zellreihe, wenn sie eine relevante Größe erreicht haben. Durch die beschriebenen relativ großen Abschnitte erfährt die elektrische Leistung des Photovoltaikmoduls eine relativ große Reduktion bei solch einer Verschattung. Ein weiterer Effekt ist, dass die elektrische Leistung der mit einer Verschattung beaufschlagten Zellreihe durch die Bypass-Diode innerhalb der Zellreihe verbraucht wird. Das kann zu einer Wärmeentwicklung an der verschatteten Zelle bzw. an den verschatten Zellen (d.h. den Zellen, die im Schatten sind) führen. Diese Wärmeentwicklung ist maßgeblich von der Größe der Verschattung als auch von der elektrischen Leistung eines Photovoltaikmoduls abhängig. Da die Module nicht nur größer, sondern auch leistungsfähiger werden, kann eine Abschattung einer Zelle bereits zu einer sehr großen Hitzeentwicklung führen.

Konventionelle Photovoltaikmodule sind offenbart in EP 2 249 394 A1, CN 109 301 010, DE 10 2011 055754 A1, US 2017/054047.

Daher besteht ein Bedarf nach Photovoltaikmodulen, die flexible, kleinere Bereiche mit Bypass-Dioden überbrücken können.

### KURZBESCHREIBUNG DER ERFINDUNG

Zumindest ein Teil der obengenannten Probleme wird durch ein Photovoltaikmodul nach Anspruch 1 und ein Verfahren zu dessen Herstellung nach Anspruch 6 gelöst. Die abhängigen Ansprüche beziehen sich auf vorteilhafte Weiterbildungen der Gegenstände der unabhängigen Ansprüche.

Die vorliegende Erfindung bezieht sich auf ein Photovoltaikmodul mit mehreren Zellreihen seriell verschalteter Photovoltaikzellen (Solarzellen) und eine oder mehrere Bypass-Komponenten. Die Zellreihen sind senkrecht zu einer Stromrichtung, die sich im Betrieb in den seriell verschalteten Photovoltaikzellen bildet, nebeneinander angeordnet und derart verschaltet, dass zumindest zwei benachbarte Zellreihen eine gleiche Stromrichtung aufweisen. Die Bypass-Komponenten überbrücken zumindest eine der benachbarten Zellreihen gleicher Stromrichtung. Die benachbarten Zellreihen können insbesondere untereinander parallel verschalten sein.

Unter einer Stromrichtung soll im Rahmen der vorliegenden Erfindung eine gerade Linie verstanden werden, entlang der die Zellreihen von Photovoltaikzellen angeordnet und seriell verschaltet sind und somit die Hauptstromrichtung angeben. An den Enden der Zellreihen erfolgt eine Umleitung der Stromrichtung und er Strom verläuft danach in die entgegengesetzte Richtung. Außerdem soll unter benachbarten Zellreihen verstanden werden, dass zwischen diesen Zellreihen keine weiteren Solarzellen angeordnet sind und im Idealfall die Solarzellen aneinandergrenzen. Es soll - abgesehen von einer elektrischen Isolierung - kein Spalt ausgebildet sein. Daher sind die mehreren Reihen optional zwischenraumlos nebeneinander angeordnet.

Die eine oder mehrere Bypass-Komponenten sind in einem Laminat mit den Zellreihen des Photovoltaikmoduls oder in einer separaten Box untergebracht. Die Box kann eine externe Box (z.B. eine Anschlussbox oder Anschlussdose) sein, die an das Laminat oder einen optionalen Rahmen befestigt wird. Die Bypass-Komponente umfasst zumindest eine der folgenden Komponenten:
- eine Bypass-Diode,
- einen Transistor (z.B. einen Feldeffekttransistor wie einen MOSFET),
- eine elektronische Schaltung (z.B. einen Stromstelle oder Spannungsteller zum Einstellen eines definierten Stromes oder einer definierten Spannung).

Auch wenn die Erfindung nicht darauf eingeschränkt sein soll, wird im Folgenden meistens eine Diode als Bypass-Komponente genutzt. Es versteht sich, dass die beispielhafte Bypass-Diode in allen Ausführungsformen durch eine andere Bypass-Komponente ersetzt werden kann.

Optional sind die beispielhaften Bypass-Dioden senkrecht zur Stromrichtung nebeneinander angeordnet (z.B. auf einer gleichen vertikalen Höhe). Beispielsweise können sie gezielt in einem bestimmten Bereich, wie z.B. in dem zentralen Bereich oder dem Randbereich, des Photovoltaikmoduls angeordnet werden. Da die Anschlussleitungen für die Bypass-Dioden beliebig gelegt werden können, können auch alle Bypass-Dioden eines Photovoltaikmoduls zentral in eine Anschlussbox integriert werden. Vorteilhafterweise sind die Bypass-Dioden auf einer Rückseite des Photovoltaikmoduls, d.h. gegenüberliegend zur Lichteinfallsrichtung, angeordnet.

Die Bypass-Dioden können auch anti-parallel zur Stromrichtung der zumindest zwei benachbarten Zellreihen gleicher Stromrichtung angeordnet sein. Unter einer antiparallelen Verschaltung ist zu verstehen, dass die Bypass-Dioden entlang der Stromrichtung in Sperrrichtung geschaltet sind. Die Bypass-Dioden führen daher im Normalbetrieb keinen Strom, sondern nur bei einer beispielhaften Abschattung, wenn es zu einem großen Spannungsabfall kommt, wodurch die abgeschatteten Solarzellen geschützt werden.

Optional umfasst das Photovoltaikmodul zumindest einen Anschlusspunkt oder eine Anschlussbox (oder Anschlussdose) in einem Eckbereich oder in einem anderen Bereich des Photovoltaikmoduls, um das Photovoltaikmodul elektrisch anzuschließen. Wenn beispielsweise die Bypass-Dioden bereits im Laminat integriert sind, braucht nur eine Anschlusspunkt als Kontaktstelle ausgebildet sein, um das Photovoltaikmodul dort elektrisch zu kontaktieren.

Mit dieser Verschaltung der Bypass-Dioden wird es möglich, das Photovoltaikmodul beliebig zu partitionieren. So können beispielsweise senkrecht zur Stromrichtung eine beliebige Anzahl von Zellreihen und/oder in Stromrichtung ebenfalls eine beliebige Anzahl von Zellreihen ausgebildet werden. Auf diese Weise können Bereiche beliebiger Größe durch eine Bypass-Diode abgeschaltet werden.

Optional sind die Photovoltaikzellen Halbzellen (oder andere Unterteilungen), die durch einen Trennprozess einer ganzen Photovoltaikzelle gefertigt werden. Unter einer Photovoltaikzelle sollen somit beliebige Formen umfasst sein (z.B. quadratische oder nicht-quadratische Formen).Innerhalb einer Zellreihe können die Photovoltaikzellen mit Verbinder elektrisch seriell verbunden werden. Sie können aber auch zum Kontaktieren mit ihren Rändern aufeinander liegen (sogenanntes Schindeln). Die Anzahl von Zellreihen und Zellen/Halbzellen innerhalb einer Zellreihe können beliebig gewählt werden.

Ausführungsbeispiele beziehen sich auch auf ein Verfahren zum Herstellen eines Photovoltaikmoduls. Das Verfahren umfasst:
- Ausbilden von mehreren Zellreihen seriell verschalteter Photovoltaikzellen, wobei die Zellreihen senkrecht zu einer Stromrichtung, die sich im Betrieb durch die seriell verschalteten Photovoltaikzellen bildet, nebeneinander angeordnet und derart verschaltet sind, dass zumindest zwei benachbarte Zellreihen eine gleiche Stromrichtung aufweisen; und
- Überbrücken von zumindest einer der benachbarten Zellreihen gleicher Stromrichtung mittels einer oder mehrerer Bypass-Dioden.

Alle zuvor genannten Merkmale des Photovoltaikmoduls können als weitere optionale Verfahrensschritte implementiert sein.

### KURZBESCHREIBUNG DER FIGUREN

Die Ausführungsbeispiele der vorliegenden Erfindung werden besser verstanden von der folgenden detaillierten Beschreibung und den beiliegenden Zeichnungen, die jedoch nicht so verstanden werden sollten, dass sie die Offenbarung auf die spezifischen Ausführungsformen einschränken, sondern lediglich der Erklärung und dem Verständnis dienen.
- Fig. 1: zeigt die Verschaltung eines Photovoltaikmodul mit Bypass-Dioden nach einem Ausführungsbeispiel der vorliegenden Erfindung.
- Fig. 2: zeigt eine schematische Verschaltung von Solarzellen-Gruppen mit Bypass-Dioden gemäß einem weiteren Ausführungsbeispiel.
- Fig. 3: zeigt ein schematisches Flussdiagramm für ein Verfahren zur Herstellung eines Photovoltaikmoduls nach einem Ausführungsbeispiel.
- Fig. 4: zeigt ein Photovoltaikmodul mit konventionell angeordneten Bypass-Dioden.

### DETAILLIERTE BESCHREIBUNG

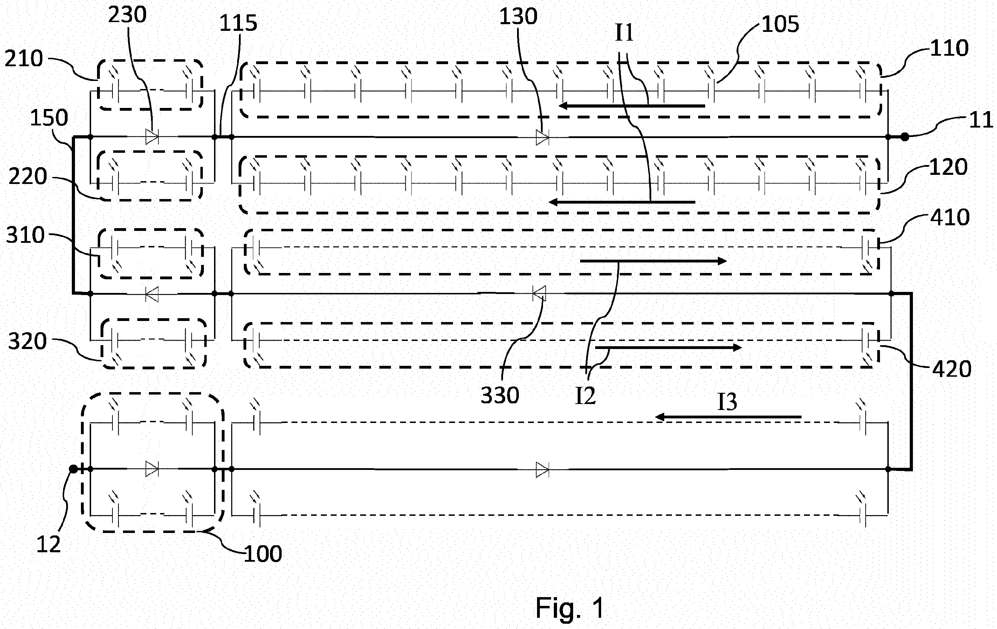

**Fig. 1** zeigt ein Photovoltaikmodul gemäß einem Ausführungsbeispiel mit mehreren Zellreihen 110, 120, 210, 220 seriell verschalteter Photovoltaikzellen 105 und mehrere Bypass-Dioden 130, 230, ... , die zwischen einem ersten Terminal 11 und einem zweiten Terminal 12 geschaltet sind. Die Zellreihen 110, 120, ... sind senkrecht zu einer Stromrichtung I1, die sich im Betrieb in den seriell verschalteten Photovoltaikzellen 105 bildet, nebeneinander angeordnet und derart verschaltet, dass zumindest zwei benachbarte Zellreihen 110, 120 eine gleiche Stromrichtung I1 aufweisen.

Konkret ist eine erste Zellreihe 110 parallel zu einer weiteren ersten Zellreihe 120 ausgebildet, wobei in den beiden ersten Zellreihen 110, 120 eine erste Stromrichtung I1 im Betrieb erzeugt wird. Stromabwärts davon sind zwei zweite Zellreihen 210, 220 von Solarzellen 105 miteinander parallel verschaltet und über eine Zwischenverbindung 115 mit den beiden ersten Zellreihen 110, 120 seriell verschaltet. Die seriell verschaltete Zellreihen 110, 120 bzw. 210, 220 bilden Gruppen 100 von Zellreihen.

Senkrecht zur ersten Stromrichtung I1 sind über einen Querverbinder 150 zwei weitere Gruppen von parallel geschalteten Zellreihen 310, 320 bzw. 410, 420 ausgebildet. Diese Verschaltung von Solarzellen 105 wiederholt sich. Jedoch hat der elektrische Querverbinder 150 die zweite Stromflussrichtung I2 umgelenkt, sodass die zweite Stromrichtung I2 durch die zweite Gruppe von Zellreihen 310, 320 bzw. 410, 420 entgegengesetzt zur ersten (anti-) parallel laufenden Stromrichtung I1 durch die erste Gruppe von Zellreihen 110, 120 bzw. 210, 220 verläuft. Die Solarzellen 105 sind dementsprechend entgegengesetzt angeordnet (oder entgegengesetzt gepolt).

Es versteht sich, dass die Anzahl von Solarzellen 105 innerhalb einer Zellreihe 110, 120, ... gemäß Ausführungsbeispielen beliebig gewählt werden kann. Ebenso können mehr als zwei Zellreihen 110, 120, ... parallel verschaltet und/oder mehr als zwei Zellgruppen 100 seriell hintereinandergeschaltet werden. Auf diese Weise kann das Photovoltaikmodul beliebig in Regionen unterteilt werden, die durch eine Bypass-Diode 130, 230, ... abschaltbar sind. Das ist bei den konventionellen Photovoltaikmodulen aus der Fig. 4 nicht möglich, da sich dort die Zellreihen über die halbe oder über die volle Modulhöhe erstrecken.

Gemäß Ausführungsbeispielen überbrückt eine erste Bypass-Dioden 130 die benachbarten ersten Zellreihen 110, 120, die beide die erste (gleiche) Stromrichtung I1 aufweisen. In gleicher Weise überbrückt eine zweite Bypass-Diode 230 die benachbarten zweiten Zellreihen 210, 220 in der nachfolgenden Gruppe von Zellreihen 210, 220, wobei auch die beiden zweiten Zellreihen 210, 220 die gleiche Stromrichtung I1 wie die ersten beiden Zellreihen 110, 120 aufweisen. Es versteht sich, dass auch mehrere kleine kürzere Strecken gebildet werden können, welche durch eine Bypass-Diode abgesichert werden. Hierbei ändert sich die Stromrichtung nicht, sondern die Strecken können mäanderförmig im Modul untergebracht werden. Senkrecht zu der Stromrichtung I1 setzt sich die Anordnung durch die mäanderförmige Anordnung der Zellreihen spiegelverkehrt fort (die Spiegelebene ist senkrecht zur Stromrichtung), sodass alle Zellenreihen seriell geschaltet sind und die ganze Modulfläche sinnvoll ausfüllen.

Somit unterscheiden sich Ausführungsbeispiele grundsätzlich von den konventionellen Photovoltaikmodulen aus der Fig. 4, wo die Bypass-Dioden Zellreihen mit gespiegelten entgegengesetzten Stromrichtungen überbrücken.

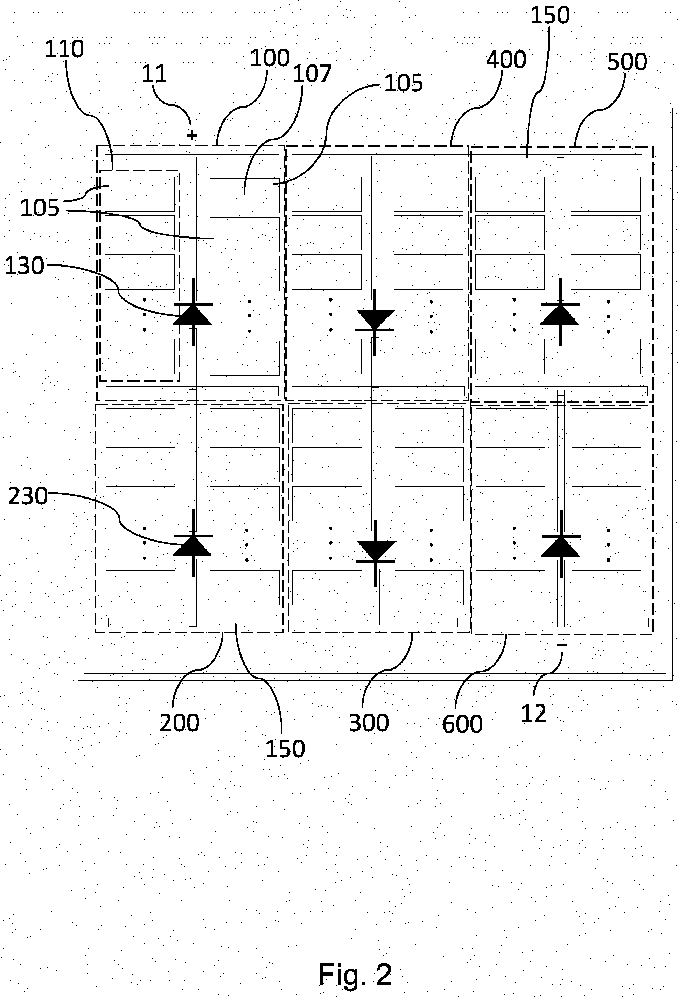

**Fig. 2** zeigt eine schematische Darstellung der Anordnung von Gruppen 100, 200, ... 600 von Zellreihen 110 zwischen dem ersten Terminal 11 und dem zweiten Terminal 12, wie sie gemäß Ausführungsbeispielen auf einem Photovoltaikmodul ausgebildet sein können. Jede Gruppe 100, 200, ... von Zellreihen 110 umfasst zwei oder mehr parallel geschaltete Zellreihen 110 von Photovoltaikzellen 105 (siehe auch Fig. 1). Die Gruppen von Zellreihen 100, 200, ... sind alle seriell verschaltet, wobei in vertikaler Richtung beispielhaft zwei seriell verschaltete Gruppen 100, 200 (bzw. 300 und 400 bzw. 500 und 600) und in horizontaler Richtung beispielhaft drei Gruppen nebeneinander gezeigt sind. Über die Querverbinder 150 wird die serielle Verschaltung aller Gruppen 100, 200, ... sichergestellt.

Es versteht sich, dass dieses Ausführungsbeispiel nur ein Beispiel darstellt. Bei weiteren Ausführungsbeispielen können mehr als zwei Zellreihen innerhalb einer Gruppe 100, 200, ... parallel verschaltet sein. Ebenso ist es möglich, dass in horizontaler Richtung mehr als drei Gruppen nebeneinander angeordnet sind bzw. in vertikaler Richtung mehr oder weniger als zwei Gruppen von Zellreihen ausgebildet sein können.

Gemäß einer vorteilhaften Ausführungsform sind die Bypass-Dioden 130, 230 auf einer Rückseite des Photovoltaikmoduls angeordnet, wobei die entsprechenden Kontaktierungspunkte über Leitungen auf die Rückseite verlegt werden. Außerdem ist es von Vorteil, wenn die Bypass-Dioden 130, 130 beispielsweise in nur einem Gehäuse (z.B. der Anschlussbox) untergebracht werden. Die Bypass-Dioden 130, 230 können aber an einer beliebigen Position auf der Rückseite angeordnet werden, wobei es von Vorteil ist, sie zumindest entlang einer Linie (nebeneinander) anzuordnen.

Außerdem ist vorteilhafterweise zwischen den Zellreihen 110 bzw. den Gruppen 100, 200, ... kein Zwischenraum ausgebildet, um Lichteinstrahlung auf der Vorderseite maximal nutzen zu können. Die Zellreihen 110, ... bzw. die Gruppen 100, 200, ... können beispielsweise bis auf eine Isolierung aneinanderstoßen.

Gemäß Ausführungsbeispielen sind die Photovoltaikzellen 105 über Verbinder 107 seriell elektrisch verbunden. Es ist aber auch möglich, dass die Photovoltaikzellen 105 an den Kanten aufeinander zu legen und so mittels Schindeln seriell verschaltet werden, um so ein verfügbare Fläche maximal nutzen zu können und eine einfache Fertigung zu ermöglichen.

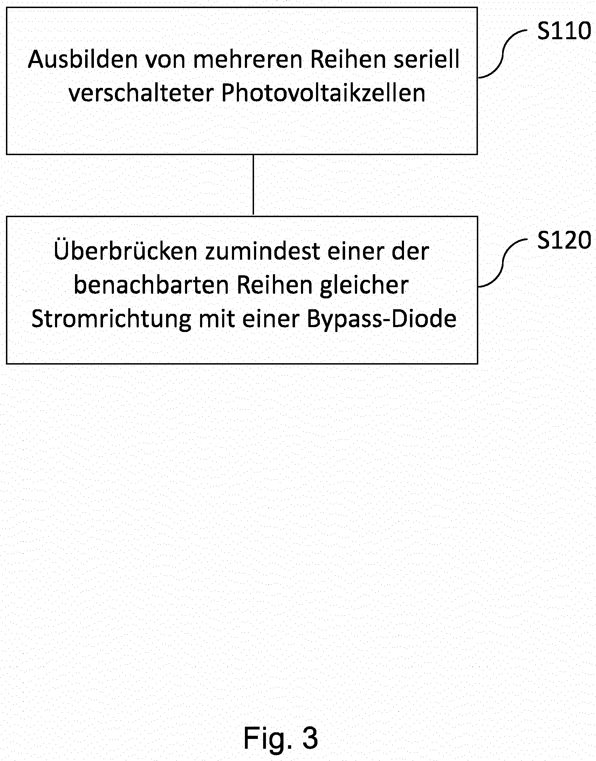

**Fig. 3** zeigt ein schematisches Flussdiagramm für ein Verfahren zur Herstellung des Photovoltaikmoduls. Das Verfahren umfasst:
- Ausbilden S110 von mehreren Zellreihen seriell verschalteter Photovoltaikzellen, wobei die Zellreihen senkrecht zu einer Stromrichtung; und
- Überbrücken S120 von zumindest einer der benachbarten Zellreihen gleicher Stromrichtung I1 mittels einer oder mehrerer Bypass-Dioden.

Es versteht sich, dass gemäß weiteren Ausführungsbeispielen alle zuvor genannten Merkmale des Photovoltaikmoduls als optionale Verfahrensschritte in dem Verfahren implementiert sein können.

Ausführungsbeispiele bieten u.a. die folgenden Vorteile:
Sehr große Photovoltaikmodule mit sehr hohen Leistungen können gezielt abschnittsweise abgeschaltet werden. Damit wird ein Höchstmaß an Schutz für die Photovoltaikzellen erreicht. Die Anzahl der Zellen, die durch eine Bypass-Diode 130, 230, ... geschützt werden, kann nahezu beliebig gewählt werden. Im konkreten Fall ist ein akzeptabler Kompromiss zwischen einem hohen Schutz der Zellen und dem Aufwand hinsichtlich der zusätzlichen Bypass-Dioden zu finden.

Ausführungsbeispiele erlauben es prinzipiell auf einfache Weise alle Zellen innerhalb einer Zellreihe 110, 120, ... zu schützen. Ein wesentlicher Nachteil von konventionellen Photovoltaikmodulen besteht darin, dass sich die zu schützenden Zellreihen zumindest über die halbe Modulhöhe erstrecken. Im Gegensatz zu diesen konventionellen Lösungen, wo immer zwei ganze Zellreihen durch eine Bypass-Diode geschützt werden, ist es bei den Ausführungsbeispielen möglich, die Anzahl der Zellen innerhalb einer Zellreihe zu reduzieren. Mit anderen Worten, das Photovoltaikmodul kann beliebig in Schutzbereiche partitioniert werden.

Schließlich sind Ausführungsbeispiele leicht umsetzbar, da auf der Rückseite Leitungen leicht ausgebildet werden können, die die Dioden zwischen den parallel angeordneten Zellreihen überbrücken.

Die in der Beschreibung, den Ansprüchen und den Figuren offenbarten Merkmale der Erfindung können sowohl einzeln als auch in beliebiger Kombination für die Verwirklichung der Erfindung wesentlich sein.

### BEZUGSZEICHENLISTE

- 11, 12: Terminals
- 41, 42: Terminals eines konventionellen Photovoltaikmoduls
- 105, 405: Photovoltaikzellen
- 100, 200, ...: Gruppen von Zellreihen
- 110, 120, ..., 410, 420, ...: Zellreihen seriell verschalteter Photovoltaikzellen
- 107: Verbinder
- 115: Zwischenverbinder
- 130, 230, ...: Bypass-Komponenten (z.B. Dioden)
- 150: Querverbinder
- 430: konventionell verschaltete Bypass-Dioden
- I1, I2, I3, ...: Stromrichtungen

## Patentansprüche

1. Ein Photovoltaikmodul mit:
mehreren Zellreihen (110, 120) seriell verschalteter Photovoltaikzellen (105), wobei die Zellreihen senkrecht zu einer Stromrichtung (I1), die sich im Betrieb in den seriell verschalteten Photovoltaikzellen (105) bildet, nebeneinander angeordnet und derart verschaltet sind, dass zumindest zwei benachbarte Zellreihen (110, 120) eine gleiche Stromrichtung (I1) aufweisen und eine zweite Gruppe von Zellreihen (310,320) eine entgegengesetzt verlaufende zweite Stromrichtung (I2) aufweisen;
einer oder mehreren Bypass-Komponenten (130, 230), die zumindest eine der benachbarten Zellreihen (110, 120) gleicher Stromrichtung (I1) überbrückt;
nur einer Anschlussbox als Anschlusspunkt, um das Photovoltaikmodul elektrisch zu kontaktieren,
wobei die mehreren Reihen (110, 120, 130, 140) zwischenraumlos nebeneinander angeordnet sind und die Bypass-Komponenten (130, 230) entgegen einer Lichteinfallsrichtung auf einer Rückseite des Photovoltaikmoduls angeordnet sind, wobei die eine oder mehreren Bypass-Komponenten (130, 230) in einem Laminat des Photovoltaikmoduls mit den Zellreihen (110, 120) untergebracht sind und zumindest eine der folgenden Komponenten umfassen:
- eine Bypass-Diode,
- einen Transistor,
- eine elektronische Schaltung.

2. Das Photovoltaikmodul nach Anspruch 1, wobei zumindest zwei Zellreihen (110, 120, 210, 220) mit gleicher Stromrichtung (I1) seriell entlang der gleichen Stromrichtung (I1) hintereinander verschaltet sind.

3. Das Photovoltaikmodul nach einem der vorhergehenden Ansprüche, wobei die Bypass-Komponenten (130, 230) senkrecht zur Stromrichtung (I1, I2, I3) nebeneinander angeordnet sind.

4. Das Photovoltaikmodul nach einem der vorhergehenden Ansprüche, wobei die Bypass-Komponenten anti-parallel zur Stromrichtung (I1, I2, I3) zu zumindest zwei benachbarten Zellreihen (110, 120, 210, 220) der gleichen Stromrichtung (I1, I2, I3) angeordnet sind.

5. Das Photovoltaikmodul nach einem der vorhergehenden Ansprüche, das weiter zumindest einen Anschlusspunkt oder eine Anschlussbox in einem Eckbereich des Photovoltaikmoduls aufweist, um das Photovoltaikmodul elektrisch anzuschließen.

6. Ein Verfahren zum Herstellen eines Photovoltaikmoduls, das Verfahren umfasst:
Ausbilden von mehreren Zellreihen seriell verschalteter Photovoltaikzellen, wobei die Zellreihen senkrecht zu einer Stromrichtung, die sich im Betrieb durch die seriell verschalteten Photovoltaikzellen bildet, nebeneinander angeordnet und derart verschaltet sind, dass zumindest zwei benachbarte Zellreihen eine gleiche Stromrichtung aufweisen; und
Überbrücken, mittels einer oder mehrerer Bypass-Komponenten, von zumindest einer der benachbarten Zellreihen gleicher Stromrichtung,
wobei die mehreren Reihen (110, 120, 130, 140) zwischenraumlos nebeneinander angeordnet werden und die Bypass-Komponenten (130, 230) entgegen einer Lichteinfallsrichtung auf einer Rückseite des Photovoltaikmoduls angeordnet werden,
wobei Photovoltaikmodul über nur eine Anschlussbox als Anschlusspunkt elektrisch kontaktiert wird,
wobei die eine oder mehreren Bypass-Komponenten (130, 230) in einem Laminat des Photovoltaikmoduls mit den Zellreihen (110, 120) untergebracht werden und zumindest eine der folgenden Komponenten umfassen:
- eine Bypass-Diode,
- einen Transistor,
eine elektronische Schaltung.

## Claims

1. A photovoltaic module comprising:
a plurality of cell rows (110, 120) of serially connected photovoltaic cells (105), wherein the cell rows are arranged one next to the other perpendicular to a current direction (11) that is formed in the serially connected photovoltaic cells (105) during operation, and are connected in such a way that at least two adjacent cell rows (110, 120) have the same current direction (11) and a second group of cell rows (310, 320) have an opposite second current direction (I2);
one or more bypass components (130, 230) that bridge at least one of the adjacent cell rows (110, 120) of the same current direction (11);
only one connection box as a connection point in order to electrically contact the photovoltaic module,
wherein the plurality of rows (110, 120, 130, 140) are arranged one next to the other without gaps and the bypass components (130, 230) are arranged on a rear side of the photovoltaic module counter to a direction of light incidence, wherein the one or more bypass components (130, 230) are housed in a laminate of the photovoltaic module with the cell rows (110, 120) and comprise at least one of the following components:
- a bypass diode,
- a transistor,
- an electronic circuit.

2. The photovoltaic module according to claim 1, wherein at least two cell rows (110, 120, 210, 220) having the same current direction (11) are connected in series one behind the other in the same current direction (11).

3. The photovoltaic module according to either of the preceding claims, wherein the bypass components (130, 230) are arranged one next to the other perpendicular to the current direction (11, I2, I3).

4. The photovoltaic module according to any of the preceding claims, wherein the bypass components are arranged anti-parallel to the current direction (11, I2, I3) with respect to at least two adjacent cell rows (110, 120, 210, 220) of the same current direction (11, I2, I3).

5. The photovoltaic module according to any of the preceding claims, which further comprises at least one connection point or a connection box in a corner region of the photovoltaic module in order to electrically connect the photovoltaic module.

6. A method for producing a photovoltaic module, the method comprising:
forming a plurality of cell rows of serially connected photovoltaic cells, wherein the cell rows are arranged one next to the other perpendicular to a current direction that is formed by the serially connected photovoltaic cells during operation, and are connected in such a way that at least two adjacent cell rows have the same current direction; and
bridging, by means of one or more bypass components, at least one of the adjacent cell rows of the same current direction,
wherein the plurality of rows (110, 120, 130, 140) are arranged one next to the other without gaps and the bypass components (130, 230) are arranged on a rear side of the photovoltaic module counter to a direction of light incidence,
wherein the photovoltaic module is electrically contacted via only one connection box as a connection point,
wherein the one or more bypass components (130, 230) are housed in a laminate of the photovoltaic module with the cell rows (110, 120) and comprise at least one of the following components:
- a bypass diode,
- a transistor,
an electronic circuit.

## Revendications

1. Module photovoltaïque comportant :
plusieurs rangées (110, 120) de cellules de cellules photovoltaïques (105) connectées en série, dans lequel les rangées de cellules sont agencées côte à côte perpendiculairement à un sens du courant (11) qui se forme en fonctionnement dans les cellules photovoltaïques (105) connectées en série, et sont connectées de telle sorte qu'au moins deux rangées (110, 120) de cellules voisines présentent un sens du courant (11) identique et qu'un second groupe de rangées (310, 320) de cellules présentent un second sens du courant (I2) opposé ;
un ou plusieurs composants de dérivation (130, 230) qui pontent au moins l'une des rangées (110, 120) de cellules voisines ayant le même sens du courant (11) ;
un seul boîtier de raccordement comme point de raccordement pour établir un contact électrique avec le module photovoltaïque,
dans lequel les plusieurs rangées (110, 120, 130, 140) sont agencées côte à côte sans espace entre elles et les composants de dérivation (130, 230) sont agencés à l'opposé d'une direction d'incidence de la lumière, sur un côté arrière du module photovoltaïque, dans lequel les un ou plusieurs composants de dérivation (130, 230) sont intégrés dans un stratifié du module photovoltaïque avec les rangées (110, 120) de cellules et comprennent au moins l'un des composants suivants :
- une diode de dérivation,
- un transistor,
- un circuit électronique.

2. Module photovoltaïque selon la revendication 1, dans lequel au moins deux rangées (110, 120, 210, 220) de cellules comportant un sens du courant (11) identique sont connectées en série les unes à la suite des autres le long du sens du courant (11) identique.

3. Module photovoltaïque selon l'une des revendications précédentes, dans lequel les composants de dérivation (130, 230) sont agencés côte à côte, perpendiculairement au sens du courant (11, I2, I3).

4. Module photovoltaïque selon l'une des revendications précédentes, dans lequel les composants de dérivation sont agencés en antiparallèle par rapport au sens du courant (11, I2, I3) d'au moins deux rangées (110, 120, 210, 220) de cellules voisines ayant un sens du courant (11, I2, I3) identique.

5. Module photovoltaïque selon l'une des revendications précédentes, qui présente en outre au moins un point de raccordement ou un boîtier de raccordement dans une zone d'angle du module photovoltaïque, afin de raccorder électriquement le module photovoltaïque.

6. Procédé de fabrication d'un module photovoltaïque, le procédé comprend :
la réalisation de plusieurs rangées de cellules photovoltaïques connectées en série, dans lequel les rangées de cellules sont agencées côte à côte perpendiculairement à un sens du courant, qui se forme, en fonctionnement, à travers les cellules photovoltaïques connectées en série, et sont connectées de telle sorte qu'au moins deux rangées de cellules voisines présentent un sens du courant identique ; et
le pontage, par le biais d'un ou plusieurs composants de dérivation, d'au moins l'une des rangées de cellules voisines ayant un sens du courant identique,
dans lequel les plusieurs rangées (110, 120, 130, 140) sont agencées côte à côte sans espace entre elles et les composants de dérivation (130, 230) sont agencés sur un côté arrière du module photovoltaïque, à l'opposé d'une direction d'incidence de la lumière,
dans lequel le module photovoltaïque établit un contact électrique par l'intermédiaire d'un seul boîtier de raccordement comme point de connexion,
dans lequel les un ou plusieurs composants de dérivation (130, 230) sont intégrés dans un stratifié du module photovoltaïque comportant les rangées (110, 120) de cellules et comprennent au moins l'un des composants suivants :
- une diode de dérivation,
- un transistor,
un circuit électronique.
